# EUROPEAN PATENT APPLICATION

(11) **EP 4 657 088 A1**
(43) Date of publication of application: **03.12.2025**
(21) Application number: 24179335.5
(22) Date of filing: 31.05.2024
(51) Int. Cl.: G01R 31/28

(54) **TEST AND/OR MEASUREMENT SYSTEM**

(71) Applicant: Rohde & Schwarz GmbH & Co. KG, 81671 München (DE)
(72) Inventor: Ramian, Florian, 81671 München (DE); Schlembach, Florian, 81671 München (DE)
(74) Representative: Prinz & Partner mbB

(57) **Abstract**

A test and/or measurement system (10) is described. The test and/or measurement system (10) comprises a signal generator module (16) a signal analysis module (38), an output signal path (20), a first signal path (22), a second signal path (24), and an analysis signal path (32). The signal generator module (16) is configured to generate a modulated radio frequency, RF, signal based on a predefined waveform. The output signal path (20) is connected to the signal generator module and is connectable to a device under test. The first signal path (22) is connected to the signal generator module (16) so as to receive a reference signal corresponding to the modulated RF signal. The second signal path (24) is connectable to the device under test (12) so as to receive a measurement signal from the device under test (12), wherein the measurement signal corresponds to the modulated RF signal. The analysis signal path (32) is connected to both the first signal path (22) and the second signal path (24), such that the reference signal and the measurement signal are merged into the analysis signal path (32), thereby obtaining an analysis signal. The signal analysis module (38) is configured to analyze the analysis signal, thereby obtaining analysis data. The analysis module (38) further is configured to separate the reference signal from the measurement signal for analyzing the analysis signal based on the predefined waveform.

## Description

The present invention generally relates to a test and/or measurement system.

Certain types of measurements performed on electronic devices under test require a reference signal that is to be received in addition to a measurement signal received from the device under test.

Typically, an RF signal is generated by a signal generator module, and the RF signal is applied to the device under test. The corresponding measurement signal from the device under test is received by a first (wideband) measurement receiver, and the RF signal is additionally forwarded as a reference signal to a second (wideband) measurement receiver.

Accordingly, an additional (wideband) measurement receiver is necessary for receiving the reference signal, which significantly increases the manufacturing costs of the test and/or measurement system.

The object of the present invention is to provide a test and/or measurement system that is more cost-efficient.

According to the invention, the problem is solved by a test and/or measurement system. The test and/or measurement system comprises a signal generator module, wherein the signal generator module is configured to generate a modulated radio frequency, RF, signal based on a predefined waveform. The test and/or measurement system further comprises an output signal path, wherein the output signal path is connected to the signal generator module and is connectable to a device under test. The test and/or measurement system further comprises a signal analysis module. The test and/or measurement system further comprises a first signal path, wherein the first signal path is connected to the signal generator module so as to receive a reference signal corresponding to the modulated RF signal. The test and/or measurement system further comprises a second signal path, wherein the second signal path is connectable to the device under test so as to receive a measurement signal from the device under test, wherein the measurement signal corresponds to the modulated RF signal. The test and/or measurement system further comprises an analysis signal path, wherein the analysis signal path is connected to both the first signal path and the second signal path, such that the reference signal and the measurement signal are merged into the analysis signal path, thereby obtaining an analysis signal. The signal analysis module is configured to analyze the analysis signal, thereby obtaining analysis data. The analysis module further is configured to separate the reference signal from the measurement signal for analyzing the analysis signal based on the predefined waveform.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

The term "modulated RF signal" is understood to denote an RF signal whose amplitude, frequency, and/or phase are/is varied over time. In the context of the present disclosure, e.g. a burst of a continuous wave signal having only a predefined duration, namely a duration that is short compared to the time necessary for the RF signal to travel through the test and/ or measurement system, is considered to be a modulated signal.

Further, the term "a reference signal corresponding to the modulated RF signal" is understood to denote that the reference signal is obtained based on the modulated RF signal, such that the reference signal has the same modulation as the modulated RF signal. Further, the reference signal has a similar or the same overall shape as the modulated RF signal, albeit with a possibly different amplitude, e.g. due to attenuation in the test and/or measurement system.

Moreover, the term "the measurement signal corresponds to the modulated RF signal" is understood to denote that the measurement signal is obtained based on the modulated RF signal, such that the measurement signal has the same modulation as the modulated RF signal. For example, the measurement signal may be the modulated RF signal processed by the device under test or the modulated RF signal reflected at the device under test. The measurement signal may have an amplitude that is different from the amplitude of the modulated RF signal.

The term "merged into the analysis signal path" is understood to denote that the reference signal and the measurement signal may be forwarded to the analysis signal path simultaneously or consecutively.

If the reference signal and the measurement signal are forwarded to the analysis signal path simultaneously, the reference signal and the measurement signal are superposed, thereby obtaining the analysis signal.

If the reference signal and the measurement signal are forwarded to the analysis signal path consecutively, the analysis signal is a temporal concatenation of the reference signal and the measurement signal.

Further, the term "predetermined waveform" is understood to denote a digital waveform having known properties. The predetermined waveform may be adaptable. For example, the predetermined waveform may be adapted automatically to be suitable for testing a particular device under test. Alternatively or additionally, a user may adapt the predetermined waveform by providing a corresponding user input.

The predetermined waveform may be played back by the signal generator module, i.e. the signal generator module converts the predetermined waveform into the modulated RF signal having a certain signal level.

In general, the predetermined waveform may be suitable for performing tests on the device under test. Thus, the modulated RF signal comprising the predetermined waveform may be applied to the device under test via the output signal path.

The test and/or measurement system according to the present disclosure is based on the idea to merge the reference signal and the measurement signal, such that a single measurement receiver is sufficient for receiving the resulting analysis signal. In other words, the signal analysis module may comprise a single measurement receiver being configured to receive the analysis signal.

Accordingly, the manufacturing costs of the test and/or measurement system are reduced significantly.

Based on the a priori knowledge of the predefined waveform comprised in both the reference signal and the measurement signal, the reference signal and the measurement signal can be separated again in order to determine the analysis data.

It has turned out that the reference signal and the measurement signal can be separated reliably as long as the reference signal and the measurement signal do not overlap fully in time domain, but at most partially.

It is noted that the analysis signal path may be arranged outside of the signal analysis module, such that the merged analysis signal is fed to an input of the analysis module.

Alternatively, the analysis signal path may be arranged within the signal analysis module.

The reference signal may be fed to a first input of the signal analysis module connected to the first signal path. The measurement signal may be fed to a second input of the signal analysis module connected to the second signal path. Accordingly, the reference signal and the measurement signal may be merged within the signal analysis module.

In another variant, the first signal path and the second signal path may join at an input of the signal analysis module, such that the reference signal and the measurement signal are merged at the input of the signal analysis module.

According to an aspect of the present invention, the signal analysis module is configured to separate the reference signal from the measurement signal based on a group delay difference between the reference signal and the measurement signal. In general, as the reference signal and the measurement signal propagate though different signal paths, they have different group delays for arriving at the signal analysis module. Based on these different group delays, the signal analysis module can separate the reference signal from the measurement signal.

In an embodiment of the present invention, the first signal path has a different electrical length compared to the second signal path, particularly wherein the first signal path is electrically shorter than the second signal path. Due to the different electrical lengths, the group delays of the reference signal and the measurement signal for arriving at the signal analysis module are different from each other, and the reference signal can be separated from the measurement signal.

Particularly, if the first signal path is electrically shorter than the second signal path, the first signal arriving at the signal analysis module is known to be the reference signal, and the second signal arriving at the signal analysis module is known to be the measurement signal.

In fact, the electrical lengths of the first signal path and of the second signal path may be configured such the reference signal and the measurement signal overlap at most partially, but not fully.

In a further embodiment of the present invention, the analysis module is configured to separate the reference signal from the measurement signal based on an amplitude difference between the reference signal and the measurement signal. In general, the amplitudes of the reference signal and of the measurement signal are different from each other, such that the reference signal can be separated from the measurement signal based on the amplitude difference.

Particularly, the reference signal may have a known amplitude, which can for example be obtained in a calibration of the test and/or measurement system. Accordingly, the reference signal can be identified based on the known amplitude of the reference signal and can thus be separated from the measurement signal.

The test and/or measurement system may further comprise a first coupling module, wherein the first coupling module is configured to couple the modulated RF signal from the output signal path into the first signal path and/or the reference signal from the first signal path into the analysis signal path. Accordingly, the reference signal may be attenuated compared to the modulated RF signal according to the coupling characteristics of the first coupling module.

In an embodiment of the present invention, the first coupling module comprises a first directive element, wherein the first directive element is connected to the output signal path and to the first signal path, and wherein the first directive element is configured to couple the modulated RF signal from the output signal path into the first signal path, thereby obtaining the reference signal. Thus, the reference signal is attenuated compared to the modulated RF signal based on the coupling characteristics of the first directive element, namely a coupling factor of the first directive element.

For example, the first directive element may be a directional coupler.

As another example, the first directive element may be a power combiner, a splitter, or a multiplexer.

Hereinafter, the term "directive element" is understood to denote a directional coupler, a splitter, a multiplexer, or functionally similar components.

Another aspect of the present invention provides that the first coupling module comprises a second directive element, wherein the second directive element is connected to the first signal path and to the analysis signal path, and wherein the second directive element is configured to couple the reference signal into the analysis signal path. Thus, the reference signal is attenuated compared to the modulated RF signal based on the coupling characteristics of the second directive element, namely a coupling factor of the second directive element.

It is noted that the signal analysis module may be configured to identify the reference signal based on a known signal level of the modulated RF signal and based on the known coupling characteristics of the first coupling module, particularly based on the known coupling characteristics of the first directive element and/or the known coupling characteristics of the second directive element.

The test and/or measurement system may further comprise a switching module, wherein the switching module is connected to the first signal path, the second signal path, and the analysis signal path, and wherein the switching module is configured to selectively forward the reference signal or the measurement signal to the analysis signal path. Thus, the reference signal and the measurement signal may be forwarded to the analysis signal path consecutively by the switching module, such that the analysis signal is a concatenation of the reference signal and of the measurement signal.

For example, the switching module may be controlled to selectively connect the first signal path or the second signal path to the analysis signal path based on expected group delays of the reference signal and of the measurement signal.

According to an aspect of the present invention, the test and/or measurement system further comprises a second coupling module, wherein the second coupling module is configured to couple the measurement signal into the second signal path and/or the measurement signal into the analysis signal path. In other words, the second coupling module may be configured to forward the measurement signal to the analysis signal path.

In a further embodiment of the present invention, the second coupling module comprises a third directive element, wherein the third directive element is connected to the output signal path and to the second signal path, and wherein the third directive element is configured to couple a signal reflected by the device under test into the second signal path, wherein the reflected signal is the measurement signal. In other words, the measurement signal, i.e. the modulated RF signal being reflected at the device under test, particularly at an input of the device under test, is coupled into the second signal path by the third directive element, and is thus forwarded to the analysis signal path.

According to another aspect of the present invention, the second signal path and the analysis signal path are formed as a single signal line. In other words, the test and/or measurement system may comprise a continuous electrical signal line that comprises both the analysis signal path and the second signal path.

The test and/or measurement system may further comprise a first port, wherein the output signal path connects the signal generator module to the first port, and wherein the first port is connectable to the device under test, particularly to an input of the device under test. Thus, the modulated RF signal may be forwarded to the device under test via the output signal path and the first port.

A reflected signal that is reflected at the device under test may be transmitted back to the output signal line via the first port, and may be coupled into the second signal path by the third directive element described above.

Another aspect of the present invention provides that the test and/or measurement system further comprises at least a second port, wherein the second port is connectable to the device under test, particularly to an output of the device under test. Accordingly, the second port may be configured to receive an output signal of the device under test.

It is to be understood that the test and/or measurement system may comprise an arbitrary number of ports. Thus, the test and/or measurement system may comprise N ports, wherein N is a natural number greater than or equal to 1.

In fact, the measurement signal may be an output signal of the device under test corresponding to the modulated RF signal. In other words, the device under test may process the modulated RF signal, thereby obtaining the output signal and thus the measurement signal.

According to an aspect of the present invention, the second signal path is connected to the second port. Thus, the output signal of the device under test, i.e. the measurement signal, may be forwarded to the second signal path and thus to the analysis signal path via the second port.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a first variant of a test and/or measurement system according to the present invention;
- Figure 2 schematically shows a diagram of an analysis signal plotted against time;
- Figure 3 schematically shows a second variant of a test and/or measurement system according to the present invention; and
- Figure 4 schematically shows a third variant of a test and/or measurement system according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

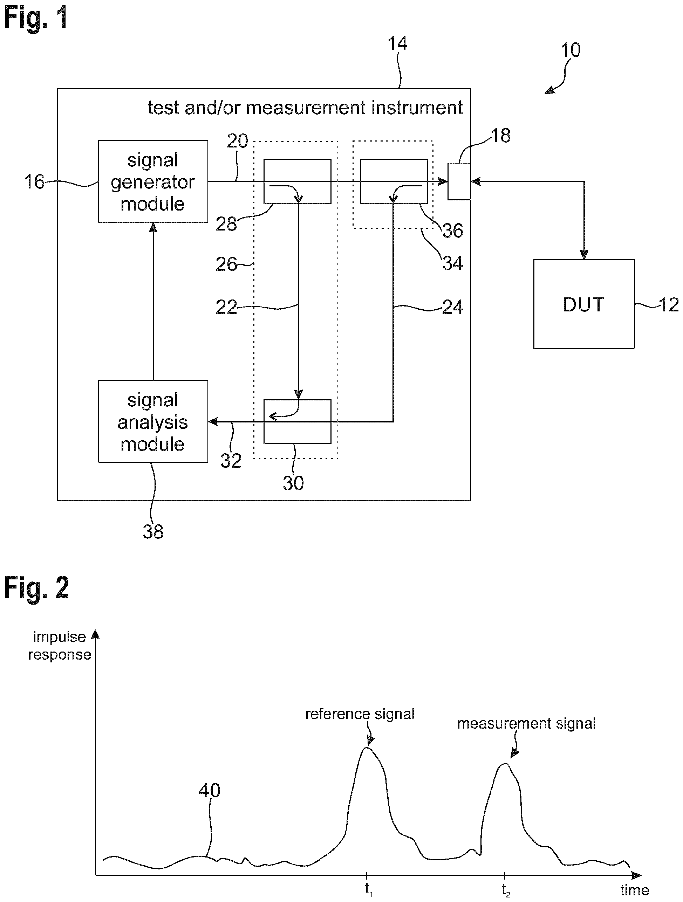

Figure 1 schematically shows a test and/or measurement system 10 that comprises a device under test 12 and a test and/or measurement instrument 14.

The device under test 12 may be any type of electronic device that is configured to generate and/or process radio frequency, RF, signals.

In general, the test and/or measurement instrument 14 is configured to perform measurements on the device under test 12 in order to assess the performance of the device under test 12.

For example, the test and/or measurement instrument 14 may be a vector network analyzer, an oscilloscope, a spectrum analyzer, or a signal analyzer.

However, it is to be understood that the test and/or measurement instrument 14 may be established as any other suitable type of test and/or measurement instrument.

The test and/or measurement instrument 14 comprises a signal generator module 16 that is connected to a first port 18 of the test and/or measurement instrument 14 by an output signal path 20.

In general, the signal generator module 16 is configured to generate a modulated RF signal based on a predetermined waveform, i.e. based on a digital waveform having known properties.

In other words, the signal generator module 16 may convert the predetermined waveform being a digital signal into the modulated RF signal by playing back the predetermined waveform.

The device under test 12 is connected to the first port 18, such that the modulated RF signal generated by the signal generator module 16 is forwarded to the device under test 12 via the output signal path 20 and the first port 18.

Particularly, an input of the device under test 12 is connected to the first port 18.

For example, the device under test 12 may be connected to the first port 18 via a suitable cable.

The test and/or measurement instrument 14 further comprises a first signal path 22 and a second signal path 24 that are each coupled to the output signal path 20.

More precisely, the first signal path 22 is coupled to the output signal path 20 by a first coupling module 26 comprising a first directive element 28.

The first directive element 28 is connected to the signal generator module 16, to the first port 18, and to the first signal path 22.

In the exemplary embodiment shown in Figure 1, the first directive element 28 comprises an electrical connection connecting the signal generator module 16 to the first port 18. Moreover, the first directive element 28 provides an electromagnetic coupling of signals traveling from the signal generator module 16 towards the first port 18 into the first signal path 22.

Thus, the modulated RF signal generated by the signal generator module 16 is partially coupled into the first signal path 22, thereby obtaining a reference signal.

A signal level of the reference signal in the first signal path 22 depends on the signal level of the modulated RF signal and a coupling factor of the first directive element 28.

The first coupling module 26 further comprises a second directive element 30 that is connected to the first signal path 22, the second signal path 24, and an analysis signal path 32.

In the exemplary embodiment shown in Figure 1, the analysis signal path 32 and the second signal path 24 are formed as a single electrical signal line that extends through the second directive element 30.

The second directive element 30 provides an electromagnetic coupling between the first signal path and the analysis signal path 32, such that the reference signal is coupled into the analysis signal path 32.

A signal level of the reference signal in the analysis signal path 32 depends on the signal level of the reference signal in the first signal path 22 and a coupling factor of the second directive element 30.

In the exemplary embodiment of Figure 1, the second signal path 24 is coupled to the output signal path 20 by a second coupling module 34, more precisely by a third directive element 36 of the second coupling module 34.

The third directive element 36 is connected to the signal generator module 16, to the first port 18, and to the second signal path 24.

In the exemplary embodiment shown in Figure 1, the second directive element 36 comprises an electrical connection connecting the signal generator module 16 to the first port 18. Moreover, the second directive element 36 provides an electromagnetic coupling of signals traveling from the first port 18 towards the signal generator module 16 into the second signal path 24.

Accordingly, the third directive element 36 couples a reflected signal into the second signal path 24, thereby obtaining a measurement signal.

In fact, the reflected signal is the modulated RF signal being reflected at the device under test 12, at least if the impedance of the device under test 12 is not perfectly matched to the impedance of the test and/or measurement instrument 14.

At the second directive element 30, the reference signal and the measurement signal are merged or rather superposed, thereby obtaining an analysis signal that is forwarded to the analysis signal path 32.

The test and/or measurement instrument 14 further comprises a signal analysis module 38 that is connected to the analysis signal path 32 so as to receive the analysis signal.

In general, the signal analysis module 38 is configured to analyze the analysis signal, thereby obtaining analysis data.

Particularly, the analysis data comprises at least one scattering parameter of the device under test 12.

In the particular measurement setup shown in Figure 1, the analysis data may comprise an S11 parameter of the device under test 12 or, if the first port 18 is connected to an output of the device under test 12, an S22 parameter of the device under test 12.

It is understood that the signal analysis module 38 may comprise all types of components that are necessary and/or suitable for performing the analysis, such as an analog-to-digital converter, a mixer, filters, amplifiers, attenuators, etc.

However, in general the signal analysis module 38 may digitize the analysis signal and may perform subsequent analysis based on the digitized analysis signal.

In order to determine the analysis data described above, the analysis module 38 is configured to separate the reference signal from the measurement signal based on the predefined waveform, i.e. based on the knowledge of the predetermined waveform being comprised in both the reference signal and the measurement signal.

In fact, the analysis module 38 may be configured to separate the reference signal from the measurement signal based on a group delay difference between the reference signal and the measurement signal, i.e. based on different group delays of the reference signal and of the measurement signal.

As is schematically illustrated in Figure 2, which shows a plot 40 of the merged analysis signal over time, the reference signal has a first group delay t₁ for reaching the signal analysis module 38, while the measurement signal has a second group delay t₂ for reaching the signal analysis module 38.

In the example shown in Figure 2, the first group delay t₁ is smaller than the second group delay t₂.

The cause of these different group delays are different electrical lengths of the paths travelled by the reference signal and the measurement signal.

On one hand, the reference signal travels along a portion of the output signal path 20 up to the first directive element 28, and along the first signal path 22.

On the other hand, the measurement signal travels along the complete output signal path 20 to the device under test 12 via the first port 18, back to the third directive element 36, and along the second signal path 22.

By choosing appropriate electrical lengths of the first signal path 22 and/or of the second signal path 24, it can be ensured that the reference signal and the measurement signal overlap at most partially in time domain, but not completely. This way, it is ensured that the reference signal and the measurement signal can be separated.

In a particular example, the electrical length of the first signal path 22 may be smaller than the electrical length of the second signal path 24, such that the group delay of the reference signal is smaller than the group delay of the measurement signal.

Alternatively or additionally to separating the reference signal from the measurement signal based on the group delay difference, the signal analysis module 38 may be configured to separate the reference signal from the measurement signal based on an amplitude difference between the reference signal and the measurement signal.

In fact, the reference signal may have a known amplitude, which can for example be obtained in a calibration of the test and/or measurement system 10. Accordingly, the reference signal can be identified based on the known amplitude of the reference signal and can thus be separated from the measurement signal.

In a particular example, the signal analysis module 38 may be configured to identify the reference signal based on a known signal level of the modulated RF signal and based on the known coupling characteristics of the first coupling module 26, particularly based on the known coupling factor of the first directive element 28 and/or the known coupling factor of the second directive element 30.

It is noted that the signal analysis module 38 may be configured to generate the predetermined waveform and/or to receive the predetermined waveform, e.g. via suitable user interface.

The signal analysis module 38 may further be configured to transmit the predetermined waveform to the signal generator module 16 via a suitable data connection.

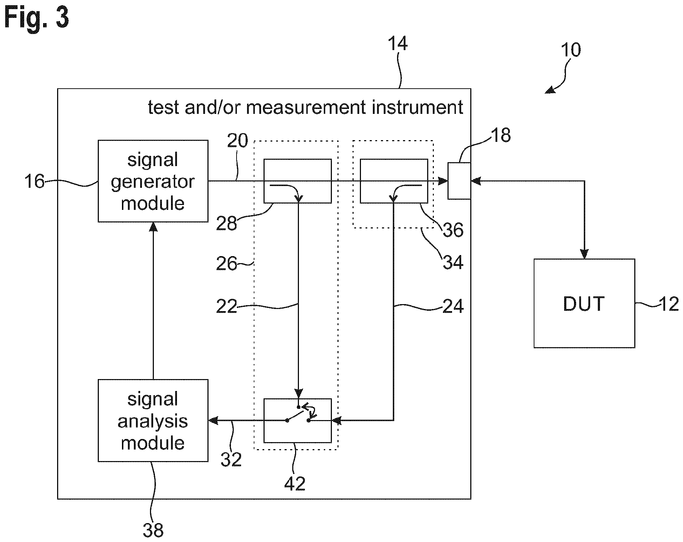

Figure 3 shows a further exemplary variant of the test and/or measurement system 10, wherein only the differences compared to the first variant described above are explained hereinafter.

In this exemplary variant, the test and/or measurement instrument 14 or rather the first coupling module 26 comprises a switching module 42 that is connected to the first signal path 22, the second signal path 24, and the analysis signal path 32.

The switching module 42 is configured to selectively forward the reference signal or the measurement signal to the analysis signal path 32, such that the reference signal and the measurement signal are forwarded to the analysis signal path 32 consecutively by the switching module 42.

For example, the switching module 42 may be controlled to selectively connect the first signal path 22 or the second signal path 24 to the analysis signal path 32 based on expected group delays of the reference signal and of the measurement signal.

Further, in the exemplary embodiment shown in Figure 3, the first coupling module 26 only comprises the first directive element 28, while the second directive element 30 described above is omitted.

Otherwise, the explanations given above with respect to Figures 1 and 2 likewise apply.

It is noted that the first directive element 28 may also be replaced by a further switching module that is configured to selectively connect the signal generator module 16 to the first signal path 22 or to the first port 18.

In this case, the switching modules together selectively forward the reference signal from the signal generator module 16 to the signal analysis module 38, or the modulated RF signal to the first port 18 and the corresponding measurement signal to the signal analysis module 38.

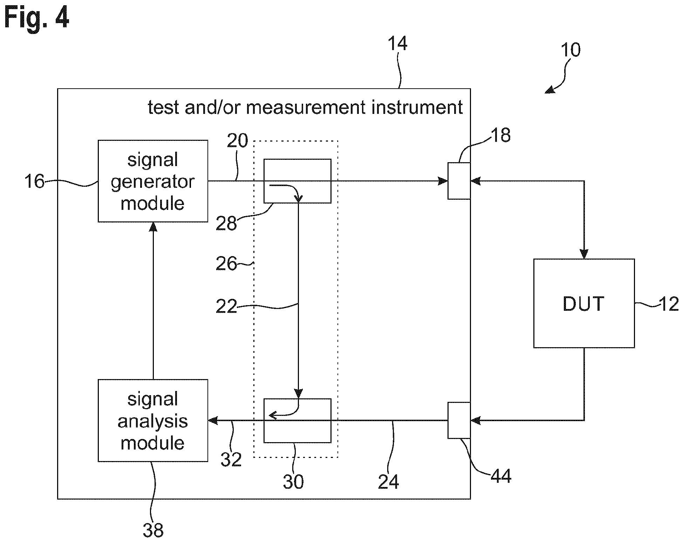

Figure 4 shows a further exemplary embodiment of the test and/or measurement system 10, wherein only the differences compared to the other variants described above are explained hereinafter.

The test and/or measurement instrument 14 comprises a second port 44 that is connected to the device under test 12, particularly to an output of the device under test 12.

It is to be understood that, in general, the test and/or measurement system 10 or rather the test and/or measurement instrument 14 may comprise an arbitrary number of ports. Thus, the test and/or measurement instrument 14 may comprise N ports, wherein N is a natural number greater than or equal to 1.

The second signal path 24 is connected to both the analysis signal path 32 and to the second port 44.

In the exemplary embodiment shown in Figure 4, the modulated RF signal is forwarded to the device under test 12 as described above.

The device under test 12 processes the modulated RF signal, thereby obtaining an output signal that is forwarded to the second signal path 24 via the second port 44.

Accordingly, the output signal of the device under test 12 is the measurement signal.

Thus, in this exemplary embodiment, the analysis data may comprise a scattering parameter of the device under test 12 describing a transmission, for example an S12 parameter or an S21 parameter.

Further, it is noted that the second coupling module 34 may be omitted.

Otherwise, the explanations given above likewise apply.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A test and/or measurement system, the test and/or measurement system (10) comprising
a signal generator module (16), wherein the signal generator module (16) is configured to generate a modulated radio frequency, RF, signal based on a predefined waveform,
an output signal path (20), wherein the output signal path (20) is connected to the signal generator module (16) and is connectable to a device under test (12),
a signal analysis module (38),
a first signal path (22), wherein the first signal path (22) is connected to the signal generator module (16) so as to receive a reference signal corresponding to the modulated RF signal,
a second signal path (24), wherein the second signal path (24) is connectable to the device under test (12) so as to receive a measurement signal from the device under test (12), wherein the measurement signal corresponds to the modulated RF signal, and
an analysis signal path (32), wherein the analysis signal path (32) is connected to both the first signal path (22) and the second signal path (24), such that the reference signal and the measurement signal are merged into the analysis signal path (32), thereby obtaining an analysis signal,
wherein the signal analysis module (38) is configured to analyze the analysis signal, thereby obtaining analysis data, and wherein the analysis module (38) is configured to separate the reference signal from the measurement signal for analyzing the analysis signal based on the predefined waveform.

2. The test and/or measurement system of claim 1, wherein the signal analysis module (38) is configured to separate the reference signal from the measurement signal based on a group delay difference between the reference signal and the measurement signal.

3. The test and/or measurement system according to any one of the preceding claims, wherein the first signal path (22) has a different electrical length compared to the second signal path (24), particularly wherein the first signal path (22) is electrically shorter than the second signal path (24).

4. The test and/or measurement system according to any one of the preceding claims, wherein the signal analysis module (38) is configured to separate the reference signal from the measurement signal based on an amplitude difference between the reference signal and the measurement signal.

5. The test and/or measurement system according to any one of the preceding claims, further comprising a first coupling module (26), wherein the first coupling module (26) is configured to couple the modulated RF signal from the output signal path (20) into the first signal path (22) and/or the reference signal from the first signal path (22) into the analysis signal path (32).

6. The test and/or measurement system of claim 5, wherein the first coupling module (26) comprises a first directive element (28), wherein the first directive element (28) is connected to the output signal path (20) and to the first signal path (22), and wherein the first directive element (28) is configured to couple the modulated RF signal from the output signal path (20) into the first signal path (22), thereby obtaining the reference signal.

7. The test and/or measurement system of claim 5 or 6, wherein the first coupling module (26) comprises a second directive element (30), wherein the second directive element (30) is connected to the first signal path (22) and to the analysis signal path (32), and wherein the second directive element (30) is configured to couple the reference signal into the analysis signal path (32).

8. The test and/or measurement system according to any one of the preceding claims, further comprising a switching module (42), wherein the switching module (42) is connected to the first signal path (22), the second signal path (24), and the analysis signal path (32), and wherein the switching module (42) is configured to selectively forward the reference signal or the measurement signal to the analysis signal path (32).

9. The test and/or measurement system according to any one of the preceding claims, further comprising a second coupling module (34), wherein the second coupling module (34) is configured to couple the measurement signal into the second signal path (24) and/or the measurement signal into the analysis signal path (32).

10. The test and/or measurement system of claim 9, wherein the second coupling module (34) comprises a third directive element (36), wherein the third directive element (36) is connected to the output signal path (20) and to the second signal path (24), and wherein the third directive element (36) is configured to couple a signal reflected by the device under test (12) into the second signal path (24), wherein the reflected signal is the measurement signal.

11. The test and/or measurement system according to any one of the preceding claims, wherein the second signal path (24) and the analysis signal path (32) are formed as a single signal line.

12. The test and/or measurement system according to any one of the preceding claims, further comprising a first port (18), wherein the output signal path (20) connects the signal generator module (16) to the first port (18), and wherein the first port (18) is connectable to the device under test (12), particularly to an input of the device under test (12).

13. The test and/or measurement system according to any one of the preceding claims, further comprising at least a second port (44), wherein the second port (44) is connectable to the device under test (12), particularly to an output of the device under test (12).

14. The test and/or measurement system of claim 13, wherein the measurement signal is an output signal of the device under test (12) corresponding to the modulated RF signal.

15. The test and/or measurement system of claim 13 or 14, wherein the second signal path (24) is connected to the second port (44).
